# EUROPEAN PATENT APPLICATION

(11) **EP 4 664 527 A1**
(43) Date of publication of application: **17.12.2025**
(21) Application number: 25178141.5
(22) Date of filing: 22.05.2025
(51) Int. Cl.: H01L 25/075, H10H 29/80, H10H 29/856

(54) **DISPLAY DEVICE**

(30) Priority: 11.06.2024 CN 202410746641
(71) Applicant: InnoLux Corporation, Jhunan Town Miao li 35053 (TW)
(72) Inventor: KUO, Shu-Ming, 35053 Jhunan Town, Miaoli County (TW); SHIH, Jian-Jung, 35053 Jhunan Town, Miaoli County (TW); HSIEH, Tsau-Hua, 35053 Jhunan Town, Miaoli County (TW)
(74) Representative: Becker, Eberhard

(57) **Abstract**

The display device provided in the disclosure includes a circuit substrate, a plurality of light-emitting units, a light collection layer, a light adjustment layer, and a color filter layer. The light-emitting units are disposed on the circuit substrate. The light collection layer is disposed on the light-emitting units and includes a plurality of penetrating portions and a plurality of reflecting portions disposed around the penetrating portions. The penetrating portions respectively overlap with the light-emitting units. The light adjustment layer is disposed on the light collection layer. The color filter layer is disposed on the light adjustment layer and includes a plurality of color filter units respectively overlapping with the penetrating portions.

## Description

### BACKGROUND

### Technical Field

The disclosure relates to a display device; more particularly, the disclosure relates to a panoramic head-up display (PHUD).

### Description of Related Art

A PHUD is a display device that utilizes the principle of optical reflection. Specifically, by projecting images and/or text displayed by the PHUD onto a windshield and reflecting them into a user's eyes, the user is able to observe the desired information without the need to look down intentionally. However, due to the difference in the reflectance between P-polarized waves (P-waves) and S-polarized waves (S-waves) at relatively large angles, it is challenging to improve the utilization efficiency of light.

### SUMMARY

Some embodiments of the disclosure are directed to a display device that may improve the utilization efficiency of light.

According to some embodiments of the disclosure, a display device includes a circuit substrate, a plurality of light-emitting units, a light collection layer, a light adjustment layer, and a color filter layer. The light-emitting units are disposed on the circuit substrate. The light collection layer is disposed on the light-emitting units and includes a plurality of penetrating portions and a plurality of reflecting portions disposed around the penetrating portions, and the penetrating portions respectively overlap with the light-emitting units. The light adjustment layer is disposed on the light collection layer. The color filter layer is disposed on the light adjustment layer and includes a plurality of color filter units respectively overlapping with the penetrating portions.

In view of the above, the display device provided in the disclosure includes a stacked structure design of the light collection layer, the light adjustment layer, and the color filter layer, where the light adjustment layer may adjust an emission angle and/or a polarization state of light, so that the display device provided in the disclosure may improve the utilization efficiency of light.

Several exemplary embodiments accompanied with figures are described in detail below to further describe the disclosure in details.

### BRIEF DESCRIPTION OF THE DRAWINGS

The accompanying drawings are included to provide a further understanding of the disclosure, and are incorporated in and constitute a part of this specification. The drawings illustrate exemplary embodiments of the disclosure and, together with the description, serve to explain the principles of the disclosure.
FIG. 1A is a schematic partial diagram illustrating an application environment of a display device according to an embodiment of the disclosure.
FIG. 1B is a curve graph showing a relationship between a reflectance and P-waves and S- waves in light emitted by a display device according to an embodiment of the disclosure.
FIG. 2A is a schematic partial cross-sectional diagram of a display device according to a first embodiment of the disclosure.
FIG. 2B is a schematic partial cross-sectional diagram of light-emitting units in a display device according to an embodiment of the disclosure.
FIG. 2C is a schematic partial cross-sectional diagram of a light adjustment layer in a display device according to an embodiment of the disclosure.
FIG. 3 is a schematic diagram illustrating a relationship among an incident angle of light emitted from light-emitting units to a light adjustment layer, a wavelength of the light, and a penetration rate in a display device according to an embodiment of the disclosure.
FIG. 4 is a schematic partial cross-sectional diagram of a display device according to a second embodiment of the disclosure.
FIG. 5 is a schematic partial cross-sectional diagram of a display device according to a third embodiment of the disclosure.
FIG. 6 is a schematic partial cross-sectional diagram of a display device according to a fourth embodiment of the disclosure.
FIG. 7 is a schematic partial cross-sectional diagram of a display device according to a fifth embodiment of the disclosure.
FIG. 8 is a schematic partial cross-sectional diagram of a display device according to a sixth embodiment of the disclosure.

### DESCRIPTION OF THE EMBODIMENTS

Reference will now be made in detail to the exemplary embodiments of the disclosure, examples of which are illustrated in the accompanying drawings. Whenever possible, the same reference numbers are used in the drawings and the description to refer to the same or like parts.

The disclosure may be understood with reference to the following detailed description with the drawings. Note that for clarity of description and ease of understanding, the drawings of the disclosure show a part of an electronic device, and certain components in the drawings may not be drawn to scale. In addition, the number and size of each device shown in the drawings simply serve for exemplifying instead of limiting the scope of the disclosure.

Certain words will be used to refer to specific devices throughout the specification and the appended claims of the disclosure. People skilled in the art should understand that manufacturers of electronic devices may refer to same elements under different names. The disclosure does not intend to distinguish devices with the same functions but different names. In the following specification and claims, the terminologies " including," "comprising," "having," etc. are open-ended terminologies, so they should be interpreted to mean "including but not limited to ...". Therefore, when the terminologies " including," "comprising," and/or "having" are used in the description of the disclosure, the terminologies designate the presence of a corresponding feature, region, step, operation, and/or component but do not exclude the presence of one or more corresponding features, regions, steps, operations, and/or components.

The directional terminologies mentioned in the disclosure, such as "upper," "lower," "front," "rear," "left," "right," and so on, are used with reference to the accompanying drawings. Therefore, the directional terminologies used are for illustration, but not to limit the disclosure. In the accompanying drawings, each drawing shows the general features of the methods, structures and/or materials adopted in a specific embodiment. However, the drawings should not be construed as defining or limiting the scope or nature covered by the embodiments. For instance, for clarity, the relative size, thickness, and position of each layer, region, and/or structure may be reduced or enlarged.

When a corresponding element (such as a film layer or a region) is referred to as being "on another element ", the element may be directly on the other element or there may be another element between the two. On the other hand, when an element is referred to as being "directly on another element ", there is no element between the two. Also, when an element is referred to as being "on another element ", the two have a top-down relationship in the top view direction, and the element may be above or below the other element, and the top-down relationship depends on the orientation of the device.

The terminologies "equal to," "equivalent," and "same" are generally interpreted as being within 20% of a given value or range, or interpreted as being within 10%, 5%, 3%, 2%, 1%, or 0.5% of a given value or range. The ordinal numbers used in the specification and claims, such as the terminologies "first," "second," and the like, to qualify a component do not imply or represent that the component or components are preceded with any ordinal numbers, nor do they represent the order of a certain component and another component, or the order in the manufacturing method, and are used to clearly distinguish a component with one name from another component with the same name. Different terminologies may be used in the claims and the specification, and accordingly, a first component in the specification may be a second component in the claims.

Note that in the following embodiments, the technical features provided in several different embodiments may be replaced, reorganized, and mixed without departing from the spirit of the disclosure so as to complete other embodiments. The technical features of the embodiments may be mixed and matched arbitrarily as long as they do not violate the spirit of the disclosure or conflict with each other.

The electrical connection or electric connection described in this disclosure may refer to either a direct connection or an indirect connection. In the case of the direct connection, terminals of elements on two circuits are directly connected or interconnected by a conductive wire segment. In the case of the indirect connection, switches, diodes, capacitors, inductors, other appropriate elements, or combinations of the above elements may exist between terminals of elements on two circuits, which should however not be construed as a limitation in the disclosure.

In this disclosure, measurement of thickness, length, width, and area may be done by applying an optical microscope, and the thickness may be obtained by measuring a cross-sectional image in an electron microscope, which should however not be construed as a limitation in the disclosure. Additionally, certain errors between any two values or directions for comparison may be acceptable. If a first value is equal to a second value, it indicates that a margin of error of about 10% may exist between the first and second values. If a first direction is perpendicular to a second direction, an angle difference between the first direction and the second direction may be between 80 degrees and 100 degrees; if the first direction is parallel to the second direction, an angle difference between the first direction and the second direction may be between 0 degrees and 10 degrees.

The electronic device provided in the disclosure may be applied to a display device, a light-emitting device, a backlight device, an antenna device, a sensing device, or a tiled device or may be a temporary substrate used to assist electronic units to be placed at specific intervals, which should however not be construed as a limitation in the disclosure. The electronic device may include a foldable or flexible electronic device. The display device may be a non-self-luminous display device or a self-luminous display device. The antenna device may be a liquid crystal antenna device or a non-liquid crystal antenna device. The sensing device may be a sensing device for sensing capacitance, light, heat, or ultrasound waves, which should however not be construed as a limitation in the disclosure. The electronic device may include passive elements, active elements, and so on, such as capacitors, resistors, inductors, diodes, transistors, and so forth. The diodes may include light-emitting diodes (LEDs) or photodiodes. The LEDs may include, for instance, organic light-emitting diodes (OLEDs), mini LEDs, micro LEDs, or quantum dot (QD) LEDs, which should however not be construed as a limitation in the disclosure. The tiled device may, for instance, include a display tiled device or an antenna tiled device, which should however not be construed as a limitation in the disclosure. It should be noted that the electronic device may be any combination of the above, which should however not be construed as a limitation in the disclosure. In addition, the shape of the electronic device tiled be rectangular, circular, polygonal, a shape with curved edges, or other appropriate shapes.

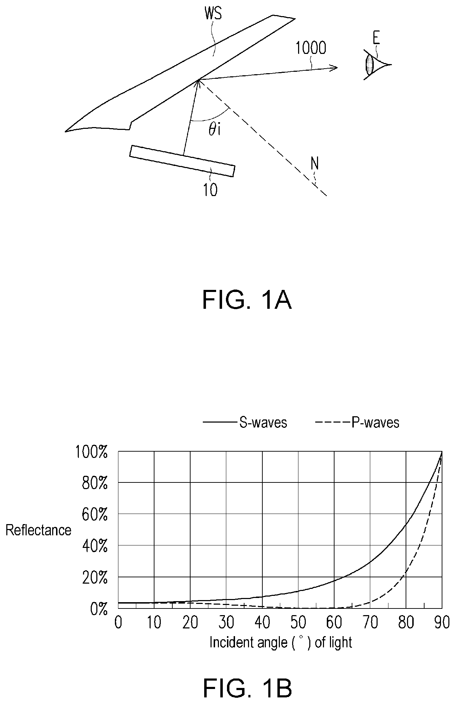

FIG. 1A is a schematic partial diagram illustrating an application environment of a display device according to an embodiment of the disclosure, and FIG. 1B is a curve graph showing a relationship between a reflectance and P- waves and S- waves in light emitted by a display device according to an embodiment of the disclosure.

Please refer to FIG. 1A, which shows a display device 10 and an environment to which the display device 10 is applied. In the present embodiment, the display device 10 is a PHUD applied in a vehicle. Specifically, the display device 10 may be disposed near a dashboard (not shown) of the vehicle (not shown), for instance, the display device 10 may emit light 1000 to a windshield WS of the vehicle to generate an image on the windshield WS by projection, and the windshield WS may reflect the light 1000 to a user's eyes E, so that the user may receive the desired information. In some embodiments, an incident angle θi exists between the light 1000 emitted by the display device 10 and a normal N of the windshield WS, where FIG. 1B is a curve graph illustrating a relationship between P-waves and S-waves in the light 1000 and a reflectance, and Table 1 shows the reflectance and an average reflectance of the P-waves and S-waves in the light 1000 at a specific incident angle θi. It may be seen from FIG. 1B and Table 1 that the reflectance of the P-waves in the light 1000 gradually decreases as the incident angle θi increases from 40° to 60°, while the reflectance of the S-waves in the light 1000 increases with the increase of the incident angle θi. Since the reflectance of the P-waves and the reflectance of the S-waves in the light 1000 are different at relatively large incident angles θi, it is challenging to improve the utilization efficiency of the light 1000. In light of the above, an embodiment of the disclosure proposes a display device 10, which may adjust the angle and/or the polarization state of the incident angle θi of the light 1000 through the design to be introduced below, thereby mitigating issues of ghost and/or glare caused by stray light and accordingly improving the utilization efficiency of the light 1000.

**Table 1**

| θi | Reflectance of S-waves | Reflectance of P-waves | Average reflectance of S-waves and P-waves |
|---|---|---|---|
| 40 | 7.7% | 1.4% | 4.6% |
| 50 | 11.2% | 0.3% | 5.8% |
| 60 | 17.7% | 0.2% | 8.9% |

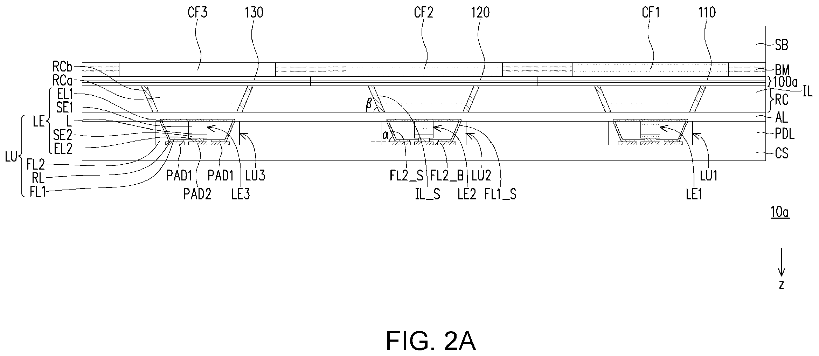

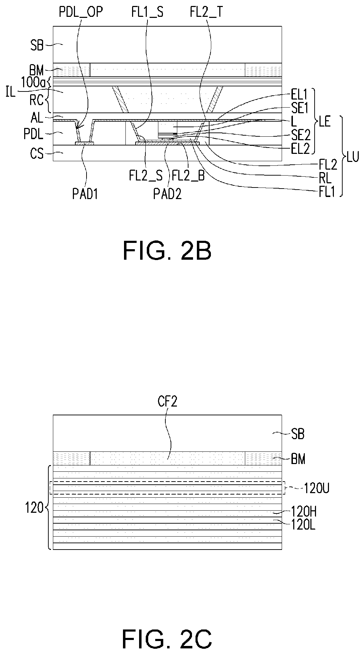

FIG. 2A is a schematic partial cross-sectional diagram of a display device according to a first embodiment of the disclosure, and FIG. 2B is a schematic partial cross-sectional diagram of light-emitting units in a display device according to an embodiment of the disclosure.

With reference to FIG. 2A, it shows that a display device 10a provided in the present embodiment includes a circuit substrate CS, a plurality of light-emitting units LU, a light collection layer RC, a light adjustment layer 100a, and a color filter layer CF.

In some embodiments, the circuit substrate CS may include a base (not shown) and an element layer (not shown).

A material of the base may, for instance, include glass, plastic, or a combination thereof. For instance, the material of the base may include quartz, sapphire, silicon (Si), germanium (Ge), silicon carbide (SiC), gallium nitride (GaN), silicon germanium (SiGe), polymethyl methacrylate (PMMA), polycarbonate (PC), polyimide (PI), polyethylene terephthalate (PET), other appropriate materials, or combinations of the above materials, which should however not be construed as a limitation in the disclosure.

The element layer may be, for instance, disposed on the base and may include, for instance, an electrical connection structure (not shown) and a thin film transistor (not shown).

The electrical connection structure may, for instance, include at least one conductive layer and at least one insulating layer alternately stacked on each other, where two adjacent conductive layers may be electrically connected to each other through an opening of the insulating layer located therebetween, such that the electrical connection structure may serve as a conductive transmission path.

The thin film transistor may be, for instance, electrically connected to the electrical connection structure. Specifically, the thin film transistor may include, for instance, a gate electrode, a source electrode, a drain electrode, and a semiconductor layer. In a top view direction z of the display device 10a, the gate electrode may, for instance, partially overlap with the semiconductor layer, and a region where the semiconductor layer overlaps with the gate electrode may be regarded as a channel region. The source electrode and the drain electrode may be, for instance, separated from each other and electrically connected to the semiconductor layer, respectively. In some embodiments, a material of the semiconductor layer may include amorphous silicon, low-temperature polysilicon (LTPS), metal oxide, other appropriate materials, or combinations thereof, where the metal oxide may include indium gallium zinc oxide (IGZO).

In the present embodiment, the circuit substrate CS further includes a pad PAD1 and a pad PAD2, the purposes of which will be detailed in the following embodiments.

The light-emitting units LU may be, for instance, disposed on the circuit substrate CS. In the present embodiment, one of the light-emitting units LU includes a light-emitting element LE, a filling layer FL1, a filling layer FL2, and a reflective layer RL, which should however not be construed as a limitation in the disclosure.

The light-emitting element LE may include, for instance, a diode, an OLED, an inorganic LED, such as a mini LED or a micro LED, a QD, a quantum dot light-emitting diode (QDLED), fluorescence, phosphor, other appropriate materials, or combinations of the above materials, which should however not be construed as a limitation in the disclosure. In the present embodiment, the light-emitting element LE is a vertical embedded flip-chip (VEFC) micro LED with a flip-chip structure, which may have characteristics of easy detection. Specifically, the light-emitting element LE may include, for instance, a first electrode EL1, a first-type semiconductor layer SE1, a light-emitting layer L, a second-type semiconductor layer SE2, and a second electrode EL2 sequentially stacked in the top view direction z of the display device 10a. The first-type semiconductor layer SE1 and the second-type semiconductor layer SE2 may each include, for instance, an N-type doped semiconductor and a P-type doped semiconductor or each include a P-type doped semiconductor and an N-type doped semiconductor. A material of the first-type semiconductor layer SE1 and the second-type semiconductor layer SE2 may include, for instance, GaN, indium gallium nitride (InGaN), gallium arsenide (GaAs), aluminum gallium indium phosphide (AlGaInP), or other materials composed of other Group IIIA and Group VA elements or other appropriate materials, which should however not be construed as a limitation in the disclosure. The light-emitting layer L may have, for instance, a quantum well (QW), which may be, for instance, a single quantum well (SQW), a multiple quantum well (MQW), or other quantum wells. In light of the foregoing, holes and electrons provided by the first-type semiconductor layer SE1 and the second-type semiconductor layer SE2 may be combined in the light-emitting layer L and emit light energy. The first electrode EL1 and the second electrode EL2 are, for instance, electrically connected to the first-type semiconductor layer SE1 and the second-type semiconductor layer SE2, respectively. In the present embodiment, the first electrode EL1 is electrically connected to the reflective layer RL, such that the first-type semiconductor layer SE1 may be electrically connected to the reflective layer RL through the first electrode EL1. In the present embodiment, the second electrode EL2 is electrically connected to the pad PAD2. A material of the first electrode EL1 and the second electrode EL2 may include, for instance, appropriate conductive materials. For instance, the material of the first electrode EL1 and the second electrode EL2 may include gold (Au), tin (Sn), copper (Cu), or other appropriate materials, which should however not be construed as a limitation in the disclosure. In the present embodiment, the first electrode EL1 is a transparent conductive layer, and its material may include a transparent conductive oxide (TCO) for reducing the possibility of interfering with the light emitted by the light-emitting elements LE.

In the present embodiment, the light-emitting units LU may include a red light-emitting unit LU1, a green light-emitting unit LU2, and a blue light-emitting unit LU3. That is, the red light-emitting unit LU1, the green light-emitting unit LU2, and the blue light-emitting unit LU3 may respectively include a red light-emitting element LE1, a green light-emitting element LE2, and a blue light-emitting element LE3, which may respectively emit red light, green light, and blue light. However, the disclosure is not limited thereto. In other embodiments, the light-emitting elements LE in each of the light-emitting units LU may all emit blue light or ultraviolet light, which may be converted into light of different colors through wavelength conversion elements (not shown) disposed above the light-emitting elements LE.

In some embodiments, the display device 10a further includes a pixel definition layer PDL.

The pixel definition layer PDL may be disposed on the circuit substrate CS, for instance, and includes a plurality of openings exposing the pad PAD 1 and the pad PAD2 of the circuit substrate CS. In some embodiments, the pixel definition layer PDL may serve to define arrangement positions of the light-emitting elements LE in each of the light-emitting units LU, where the light-emitting elements LE may be electrically connected to the pad PAD1 and the pad PAD2 through the first electrode EL1 and the second electrode EL2, respectively, which should however not be construed as a limitation in the disclosure. The pixel definition layer PDL may include, for instance, a transparent material or a light blocking material. For instance, the material of the pixel definition layer PDL may include an organic photoresist, which should however not be construed as a limitation in the disclosure.

The reflective layer RL is disposed on a sidewall FL1_S of the filling layer FL1, for instance, and is electrically connected to the pad PAD1, for instance, such that the first-type semiconductor layer SE1 may be electrically connected to the pad PAD1 through the first electrode EL1 and the reflective layer RL. In some embodiments, the reflective layer RL may serve to reduce the possibility of interference between light emitted by adjacent light-emitting elements LE and/or may serve to collimate the light emitted by the light-emitting elements LE, for instance. A material of the reflective layer RL may, for instance, include a light-absorbing material, a reflective material, a scattering material, or a combination thereof, which should however not be construed as a limitation in the disclosure. For instance, the material of the reflective layer RL may include silver (Ag), aluminum (Al), or other appropriate materials, which should however not be construed as a limitation in the disclosure. The material of the reflective layer RL may be the same as or different from the material of the first electrode EL1 and the second electrode EL2, for instance, which should however not be construed as a limitation in the disclosure.

The filling layer FL1 is disposed between the reflective layer RL and the light-emitting elements LE, for instance. In some embodiments, the filling layer FL1 may serve to fix or protect the light-emitting elements LE, and has a transmittance greater than 90% with respect to the transmittance of visible light (i.e., the light emitted by the light-emitting elements LE). A material of the filling layer FL1 may include acrylic resin, epoxy resin, siloxane resin, silicon oxide, or a combination thereof. In the present embodiment, the material of the filling layer FL1 includes siloxane resin or silicon oxide, which should however not be construed as a limitation in the disclosure.

In some embodiments, the light-emitting element LE, the reflective layer RL, and the filling layer FL1 may be packaged into a unit, and this unit may then be transferred into the openings defined by the pixel definition layer PDL, which should however not be construed as a limitation in the disclosure.

The filling layer FL2 is disposed in the openings of the pixel definition layer PDL, for instance. In some embodiments, the filling layer FL2 is disposed between the pixel definition layer PDL and the reflective layer RL and encapsulates and fixes the light-emitting element LE. Specifically, the filling layer FL2 fills a gap between the pixel definition layer PDL and the reflective layer RL. A material of the filling layer FL2 may include a transparent material, for instance. For instance, the material of the filling layer FL2 may include acrylic resin, epoxy resin, siloxane resin, silicon oxide, or a combination thereof. In the present embodiment, the material of the filling layer FL2 includes acrylic resin, which should however not be construed as a limitation in the disclosure.

In some embodiments, one of the light-emitting units LU may have a taper angle α. In the present embodiment, the taper angle α is defined as an angle between a sidewall FL2_S of the filling layer FL2 and a direction perpendicular to the top view direction z of the display device 10a, which should however not be construed as a limitation in the disclosure. In some embodiments, one of the light-emitting units LU may have a taper angle α of 10° to 80°. In some other embodiments, one of the light-emitting units LU may have a taper angle α of 30° to 70°.

In some other embodiments, the light-emitting element LE may be a vertical embedded chip (VEC) micro LED as shown in FIG. 2B. Specifically, with reference to FIG. 2B, the light-emitting element LE may include, for instance, a first electrode EL1, a first-type semiconductor layer SE1, a light-emitting layer L, a second-type semiconductor layer SE2, and a second electrode EL2 sequentially stacked in the top view direction z of the display device 10a. In the present embodiment, the reflective layer RL extends from the sidewall FL2_S of the filling layer FL2 to a bottom surface FL2_B of the filling layer FL2, and therefore the second electrode EL2 is coupled to the reflective layer RL, for instance, so as to be electrically connected to the pad PAD2 through the reflective layer RL. In addition, in the present embodiment, the reflective layer RL does not extend to the vicinity of the top surface FL2_T of the filling layer FL2, and therefore the reflective layer RL may not be electrically connected to the first electrode EL1. In the present embodiment, the pixel definition layer PDL further includes an opening PDL_OP exposing at least one portion of the pad PAD1, where the first electrode EL1 may be electrically connected to the pad PAD1 through the opening PDL_OP of the pixel definition layer PDL.

The light collection layer RC is disposed on the light-emitting units LU, for instance, and may be configured to guide the direction in which the light emitted by the light-emitting element LE travels. Specifically, the light collection layer RC may correspond to the red light-emitting element LE1, the green light-emitting element LE2, and the blue light-emitting element LE3, respectively, for instance, where the light emitted by the light-emitting elements LE may be further collimated in the corresponding light collection layer RC and provided to the light adjustment layer 100a to be introduced later, for instance. In some embodiments, the light collection layer RC may take the form of a reflective cup, and a dielectric layer IL is disposed between adjacent light collection layers RC. A material of the insulating layer IL may include an inorganic material or an organic material, for instance, which should however not be construed as a limitation in the disclosure. In the present embodiment, the light collection layer RC may also have a taper angle β, and the definition of the taper angle β is defined as an angle between a sidewall IL_S of the dielectric layer IL and a direction perpendicular to the top view direction z of the display device 10a. The range of the taper angle β of the light collection layer RC may be the same as or similar to the range of the taper angle α of the light-emitting units LU, for instance, which should however not be construed as a limitation in the disclosure. In the present embodiment, the light collection layer RC includes a plurality of penetrating portions RCa and a plurality of reflecting portions RCb disposed around the penetrating portions RCa.

The penetrating portions RCa overlap with one of the light-emitting units LU, respectively, for instance. In some embodiments, the penetrating portions RCa have high transmittance. A material of the penetrating portions RCa may include acrylic resin, epoxy resin, siloxane resin, silicon oxide, or a combination thereof. In the present embodiment, the material of the penetrating portions RCa includes acrylic resin, which should however not be construed as a limitation in the disclosure.

The reflecting portions RCb are disposed on a sidewall IL_S of the dielectric layer IL, for instance. In some embodiments, the reflecting portions RCb may be configured to reflect the light emitted by the light-emitting elements LE and restrict the light emitted by the light-emitting elements LE to be emitted within a small angular range to increase the forward light extraction efficiency of the light-emitting elements LE. A material of the reflecting portions RCb may include Ag, Al, a distributed Bragg reflector (DBR), or other appropriate materials.

In the present embodiment, the display device 10a further includes an adhesive layer AL. The adhesive layer AL is disposed between the circuit substrate CS and the light collection layer RC, for instance, so as to adhere the circuit substrate CS and the light collection layer RC to each other. The adhesive layer AL may include an optical clear resin (OCR) or an optical clear adhesive (OCA). For instance, a material of the adhesive layer AL may include acrylic resin, siloxane resin, epoxy resin, other appropriate materials, or a combination of the above materials, which should however not be construed as a limitation in the disclosure.

The light adjustment layer 100a is disposed on the light collection layer RC, for instance. In the present embodiment, the light adjustment layer 100a includes a first DBR 110, a second DBR 20, and a third DBR 130. The first DBR 110, the second DBR 120, and the third DBR 130 respectively overlap with the red light-emitting unit LU1, the green light-emitting unit LU2, and the blue light-emitting unit LU3 in the top view direction z of the display device 10a, for instance. In some embodiments, the first DBR 110, the second DBR 120, and the third DBR 130 respectively include a plurality of alternately stacked high-refractive-index sublayers and low-refractive-index sublayers. Taking the second DBR 120 shown in FIG. 2C as an example, the second DBR 120 includes a plurality of stacked laminated units 120U, where the laminated units 120U are composed of two low-refractive-index sublayers 120L and a high-refractive-index sublayer 120H disposed therebetween. The high-refractive-index sublayer 120H may have a refractive index greater than 1.6, for instance, and may include titanium oxide (TiO₂), tantalum oxide (Ta₂O₅), niobium oxide (Nb₂O₅), zirconium oxide (ZrO₂), hafnium oxide (HfO₂), aluminum oxide (Al₂O₃), or other appropriate materials. The low-refractive-index sublayer 110L may have a refractive index less than 1.5, for instance, and may include silicon dioxide (SiO₂), magnesium fluoride (MgF₂), aluminum fluoride (AlF₃), lithium fluoride (LiF), sodium fluoroaluminate (Na₃AlF₆), or other appropriate materials. In some embodiments, the total thickness of the two low-refractive-index sublayers 120L may be substantially the same as the thickness of the high-refractive-index sublayer 120H, and the two low-refractive-index sublayers 120L may have substantially the same thickness, which should however not be construed as a limitation in the disclosure. Similarly, the first DBR 110 and the third DBR 130 may also have the composition of the laminated units 120U of the second DBR 120, which will not be repeated hereinafter.

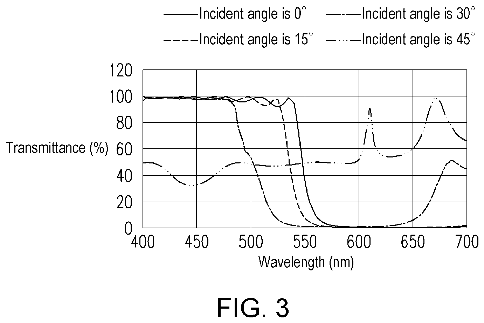

By arranging the light adjustment layer 100a, the light emitted by the light-emitting elements LE may be further confined to be emitted within a small angular range, thereby increasing the forward light extraction efficiency of the light-emitting elements LE. Specifically, with reference to FIG. 3, taking the green light-emitting element LE2 as an example, when the incident angle of the light emitted by the green light-emitting element LE2 into the second DBR 120 increases, the transmittance decreases. Therefore, when the incident angle is relatively large, the light emitted by the green light-emitting element LE2 may undergo total reflection and/or scattering, such that the emission angle of the light passing through the second DBR 120 again may be narrowed, and the resultant brightness may be improved.

In the present embodiment, at least two of the first DBR 110, the second DBR 120, and the third DBR 130 include different numbers of sublayers. Specifically, since the first DBR 110, the second DBR 120, and the third DBR 130 respectively correspond to the red light-emitting element LE1, the green light-emitting element LE2, and the blue light-emitting element LE3 that emit light of different wavelengths, by adjusting the number of sublayers of each of the first DBR 110, the second DBR 120, and the third DBR 130, the emission brightness of the corresponding light may be increased. However, the disclosure is not limited thereto. In some other embodiments, at least two of the first DBR 110, the second DBR 120, and the third DBR 130 may include sublayers of different thicknesses, and the emission brightness of the corresponding light may also be increased by adjusting the thickness of the sublayers.

The color filter layer CF is, for instance, disposed on the light adjustment layer 100a and includes, for instance, a plurality of color filter units respectively overlapping the penetrating portions RCa. Specifically, in the present embodiment, the color filter layer CF includes a red filter unit CF1, a green filter unit CF2, and a blue filter unit CF3, which respectively overlap with the red light-emitting unit LU1, the green light-emitting unit LU2, and the blue light-emitting unit LU3. By arranging the color filter layer CF, ambient light illuminating the display device 10a may be further absorbed, thereby improving an ambient contrast ratio of the display device 10a.

In the present embodiment, the display device 10a further includes a light shielding structure BM. The light shielding structure BM may be, for instance, a grid structure including a plurality of openings, and the color filter layer CF is, for instance, disposed in the corresponding openings. In some embodiments, the light shielding structure BM may include a light shielding material. For instance, the material of the light shielding structure BM may include, for instance, black resin or a metal material with low reflectance, which should however not be construed as a limitation in the disclosure.

In the present embodiment, the display device 10a further includes an opposite substrate SB. The opposite substrate SB is, for instance, disposed opposite to the circuit substrate CS, where the light-emitting units LU, the light collection layer RC, the light adjustment layer 100a, and the color filter layer CF are, for instance, located between the opposite substrate SB and the circuit substrate CS in the top view direction z of the display device 10a, which should however not be construed as a limitation in the disclosure. A material of the opposite substrate SB may be referred to as the material provided in the description of the base of the circuit substrate CS described above, which will not be repeated hereinafter.

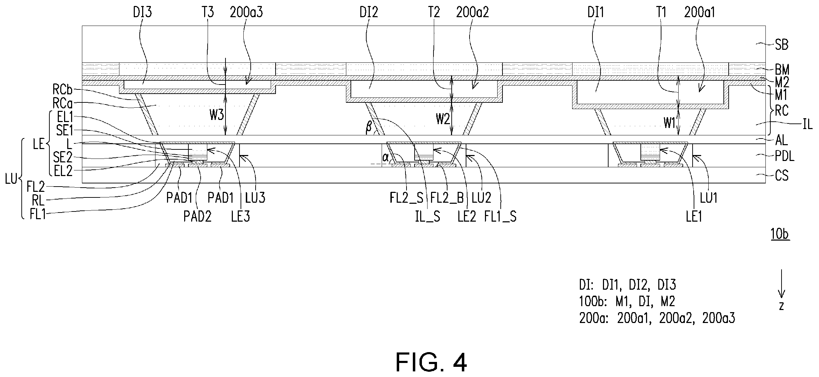

FIG. 4 is a schematic partial cross-sectional diagram of a display device according to a second embodiment of the disclosure. It should be noted that the embodiment depicted in FIG. 4 may adopt the reference numbers and some content from the embodiment depicted in FIG. 2, where the same or similar reference numbers serve to represent the same or similar elements, and the description of the same technical content is omitted.

With reference to FIG. 4, at least one difference between a display device 10b depicted in the present embodiment and the aforementioned display device 10a lies in that a light adjustment layer 100b in the display device 10b has a resonant cavity structure 200a.

Specifically, in the present embodiment, the light adjustment layer 100b includes a first metal layer M1, a dielectric layer DI, and a second metal layer M2, where the dielectric layer DI is disposed between the first metal layer M1 and the second metal layer M2.

The first metal layer M1 is, for instance, disposed on the light collection layer RC. In some embodiments, the first metal layer M1 includes a metal material with high reflectance. For instance, the material of the first metal layer M1 includes magnesium (Mg), Ag, other appropriate metal materials, or alloys of the above materials, which should however not be construed as a limitation in the disclosure.

The dielectric layer DI, for instance, includes a dielectric layer portion DI1, a dielectric layer portion DI2, and a dielectric layer portion DI3 which are separated from one another and respectively overlap with the red light-emitting unit LU1, the green light-emitting unit LU2, and the blue light-emitting unit LU3 in a top view direction z of the display device 10b. In some embodiments, the dielectric layer DI may include a transparent material. For instance, the material of the dielectric layer DI includes SiO₂, MgF₂, AlF₃, LiF, Na₃AlF₆, other appropriate materials, or combinations of the above materials, which should however not be construed as a limitation in the disclosure.

The second metal layer M2 is, for instance, disposed corresponding to the first metal layer M1, where a portion of the second metal layer M2 that does not correspond to the dielectric layer DI in the top view direction z of the display device 10b may be, for instance, in contact with the first metal layer M1, which should however not be construed as a limitation in the disclosure. A material of the second metal layer M2 may, for instance, be the same as or similar to the material of the first metal layer M1, which will not be repeated hereinafter.

In some embodiments, a metal layer/dielectric layer/metal layer stacked structure composed of fluor aluminate the first metal layer M1, the dielectric layer DI, and the second metal layer M2 disposed on the light collection layer RC may constitute the resonant cavity structure 200a, which may cause light with a specific wavelength to resonate within the cavity of the resonant cavity structure 200a. In other words, the display device 10b may include the resonant cavity structure 200a disposed between the light collection layer RC and the opposite substrate SB. In the present embodiment, the resonant cavity structure 200a may include a resonant cavity structure 200a1, a resonant cavity structure 200a2, and a resonant cavity structure 200a3, which respectively overlap with the red light-emitting unit LU1, the green light-emitting unit LU2, and the blue light-emitting unit LU3. The resonant cavity structure 200a1 is, for instance, composed of the first metal layer M1, the dielectric layer portion DI1, and the second metal layer M2; the resonant cavity structure 200a2 is, for instance, composed of the first metal layer M1, the dielectric layer portion DI2, and the second metal layer M2; the resonant cavity structure 200a3 is, for instance, composed of the first metal layer M1, the dielectric layer portion DI3, and the second metal layer M2.

In the present embodiment, the resonant cavity structures 200a1, 200a2, and 200a3 each have different thicknesses, so that light of different colors emitted by the red light-emitting unit LU1, the green light-emitting unit LU2, and the blue light-emitting unit LU3 may resonate within the corresponding resonant cavity structure 200a. Specifically, the thickness of the resonant cavity structure 200a may be obtained by dividing an integer multiple of half the wavelength of the light predetermined to resonate within the resonant cavity structure 200a by a refractive index of the dielectric layer DI, which satisfies the following equation, for instance: T=Nλ/2n, where T is the thickness of the resonant cavity structure 200a, N is an integer, λ is the wavelength of the light resonating in the resonant cavity structure 200a, and n is the refractive index of the dielectric layer DI.

In view of the above, according to the present embodiment, the thickness of the resonant cavity structure 200a may be adjusted to correspond to the wavelength of the light resonating within the resonant cavity structure 200a. In the present embodiment, the thickness of the resonant cavity structure 200a is defined as the sum of the maximum thicknesses of the first metal layer M1, the dielectric layer DI, and the second metal layer M2 in the top view direction z of the display device 10b, which should however not be construed as a limitation in the disclosure. For instance, with reference to FIG. 4, the resonant cavity structure 200a1 corresponding to the red light-emitting unit LU1 may have a thickness T1, which may be calculated, for instance, with reference to the above equation. Similarly, the thickness T2 of the resonant cavity structure 200a2 and the thickness T3 of the resonant cavity structure 200a3 may also be calculated, for instance, with reference to the above equation. Since the wavelength of red light is greater than the wavelength of green light, and the wavelength of green light is greater than the wavelength of blue light, in the present embodiment, the thickness T1 of the resonant cavity structure 200a1 may be greater than the thickness T2 of the resonant cavity structure 200a2, and the thickness T2 of the resonant cavity structure 200a2 may be greater than the thickness T3 of the resonant cavity structure 200a3.

In the present embodiment, the thickness change of the resonant cavity structure 200a is achieved by adjusting the thickness of the dielectric layer DI. In other words, the dielectric layer portions DI1, DI2, and DI3 in the different resonant cavity structures 200a1, 200a2, and 200a3 have different thicknesses. The thickness of the dielectric layer DI may be associated with the refractive index of the dielectric layer DI and the wavelength of the light resonating in the resonant cavity structure 200a. That is, the product of the thickness of the dielectric layer DI and the refractive index of the dielectric layer DI is proportional to the wavelength of the light. Specifically, when the dielectric layer portions DI1, DI2, and DI3 each include the same material, the thickness of the dielectric layer portion DI1 disposed corresponding to the red light-emitting unit LU1 is greater than the thickness of the dielectric layer portion DI2 disposed corresponding to the green light-emitting unit LU2, and the thickness of the dielectric layer portion DI2 disposed corresponding to the green light-emitting unit LU2 is greater than the thickness of the dielectric layer portion DI3 disposed corresponding to the blue light-emitting unit LU3. In view of the above, by adjusting the thicknesses of the dielectric layer portions DI1, DI2, and DI3, the thickness T1 of the resonant cavity structure 200a1, the thickness T2 of the resonant cavity structure 200a2, and the thickness T3 of the resonant cavity structure 200a3 may be adjusted, thereby changing the wavelength of the light resonating within the resonant cavity structure 200a. Since the resonant cavity structure 200a has the aforesaid specific design for the light-emitting units LU emitting different colors, when the light emitted by the red light-emitting unit LU1, the green light-emitting unit LU2, and the blue light-emitting unit LU3s is emitted from the light collection layer RC and enters the resonant cavity structure 200a, the light of different colors may resonate within the corresponding resonant cavity structure 200a. In view of the above, the intensity of the light passing through the light adjustment layer 100b in a front view direction may be improved, thereby enhancing the display effect of the display device 10b.

In some embodiments, the thickness of the first metal layer M1 and the second metal layer M2 may each be, for instance, greater than or equal to 10 nm and less than or equal to 100 nm. The first metal layer M1 and the second metal layer M2 in the different resonant cavity structures 200a1, 200a2, and 200a3 may have the same thickness, which should however not be construed as a limitation in the disclosure. In some other embodiments, the thickness of the first metal layer M1 may be greater than the thickness of the second metal layer M2, so that the reflectance of the first metal layer M1 for the resonant light is greater than the reflectance of the second metal layer M2 for the resonant light. The increase in the number of resonances of the light in the resonant cavity structure 200a may improve the color purity of the emitted light.

It is worth noting that the thickness of the light collection layer RC changes in response to the thickness of the resonant cavity structure 200a. Specifically, in the present embodiment, the stacked structure composed of the light collection layer RC and the light adjustment layer 100b has substantially the same thicknesses in portions overlapping with the red light-emitting unit LU1, the green light-emitting unit LU2, and the blue light-emitting unit LU3. Therefore, the thickness W1 of the light collection layer RC corresponding to the red light-emitting unit LU1 is less than the thickness W2 of the light collection layer RC corresponding to the green light-emitting unit LU2, and the thickness W2 of the light collection layer RC corresponding to the green light-emitting unit LU2 is less than the thickness W3 of the light collection layer RC corresponding to the blue light-emitting unit LU3.

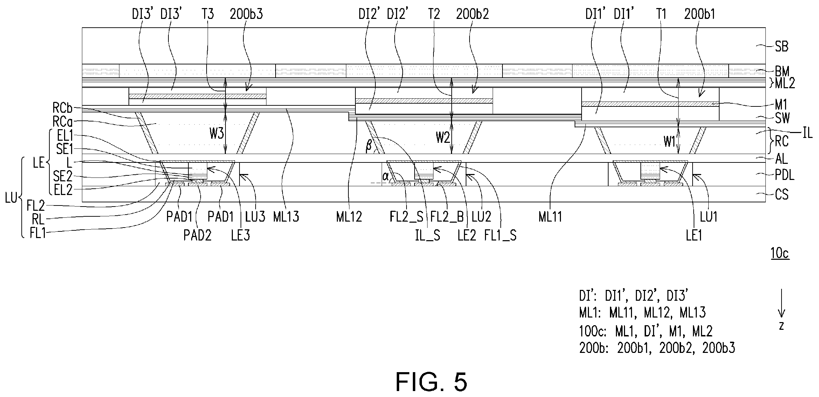

FIG. 5 is a schematic partial cross-sectional diagram of a display device according to a third embodiment of the disclosure. It should be noted that the embodiment depicted in FIG. 4 may adopt the reference numbers and some content from the embodiment depicted in FIG. 2, where the same or similar reference numbers serve to represent the same or similar elements, and the description of the same technical content is omitted.

With reference to FIG. 5, at least one difference between a display device 10c depicted in the present embodiment and the aforementioned display device 10b lies in that a resonant cavity structure 200b of a light adjustment layer 100c in the display device 10c has a design different from the design of the resonant cavity structure 200a.

Specifically, in the present embodiment, the light adjustment layer 100c includes a matching layer ML1, a matching layer ML2, two dielectric layers DI', and the first metal layer M1, where the two dielectric layers DI' and the first metal layer M1 constitute a dielectric layer/metal layer/dielectric layer stacked structure. The matching layer ML1 is, for instance, disposed on the first metal layer M1, the matching layer ML2 is, for instance, disposed between the matching layer ML1 and the opposite substrate SB, and the above dielectric layer/metal layer/dielectric layer stacked structure is, for instance, disposed between the matching layer ML1 and the matching layer ML2. That is, the two dielectric layers DI' are respectively disposed between the matching layer ML1 and the first metal layer M1 and between the first metal layer M1 and the matching layer ML2.

The matching layer ML1, for instance, has a patterned structure and overlaps with each of the red light-emitting unit LU1, the green light-emitting unit LU2, and the blue light-emitting unit LU3. Specifically, the matching layer ML1 may include a first matching layer ML11, a second matching layer ML12, and a third matching layer ML13, where the first matching layer ML11, the second matching layer ML12, and the third matching layer ML13 overlap with the red light-emitting unit LU1, the green light-emitting unit LU2, and the blue light-emitting unit LU3, respectively, in a top view direction z of the display device 10c. In some embodiments, the first matching layer ML11, the second matching layer ML12, and the third matching layer ML13 each include a plurality of alternately stacked high-refractive-index sublayers and low-refractive-index sublayers. The descriptions of the high-refractive-index sublayers and the low-refractive-index sublayers may be referred to as those provided in the previous embodiments and will not be repeated hereinafter. In some embodiments, the first matching layer ML11, the second matching layer ML12, and the third matching layer ML13 may each have a composition and thickness similar to those of the first DBR 110, the second DBR 120, and the third DBR 130, which should however not be construed as a limitation in the disclosure.

The matching layer ML2, for instance, has a film layer structure, which should however not be construed as a limitation in the disclosure. In some embodiments, the matching layer ML2 includes a plurality of alternately stacked high-refractive-index sublayers and low-refractive-index sublayers. The descriptions of the high-refractive-index sublayers and the low-refractive-index sublayers may be referred to as those provided in the previous embodiments and will not be repeated hereinafter.

Furthermore, the description of the materials included in each of the dielectric layers DI' and the first metal layer M1 may be referred to as that provided in the previous embodiments and will not be repeated hereinafter.

In the present embodiment, the display device 10c further includes a barrier wall SW. The barrier wall SW may, for instance, serve to define positions of a resonant cavity structure 200b1, a resonant cavity structure 200b2, and a resonant cavity structure 200b3. In some embodiments, the barrier wall SW may include an appropriate light shielding material or reflective material, which should however not be construed as a limitation in the disclosure.

In some embodiments, the matching layer ML1, the matching layer ML2, the two dielectric layers DI', and the first metal layer M1 disposed on the light collection layer RC may constitute a resonant cavity structure 200b, which may cause light of a specific wavelength to resonate within the cavity of the resonant cavity structure 200b. The description of the thickness of the resonant cavity structure 200b may be referred to as that provided in the previous embodiments and will not be repeated hereinafter. It is worth noting that the thickness of the dielectric layers DI' may be approximately half the thickness of the dielectric layer DI in the previous embodiments. Specifically, the thickness of a dielectric layer portion DI1' is, for instance, about half the thickness of the dielectric layer portion DI1, a thickness of the dielectric layer portion DI2' is, for instance, about half the thickness of the dielectric layer portion DI2, and the thickness of a dielectric layer portion DI3' is, for instance, about half the thickness of the dielectric layer portion DI3, which should however not be construed as a limitation in the disclosure.

Since the resonant cavity structure 200b has the specific design for the light-emitting units LU emitting different colors, when the light emitted by the red light-emitting unit LU1, the green light-emitting unit LU2, and the blue light-emitting unit LU3 is emitted from the light collection layer RC and enters the resonant cavity structure 200b, light of different colors may resonate within the corresponding resonant cavity structure 200b. In view of the above, the intensity of light passing through the light adjustment layer 100c in the front view direction may be improved, thereby enhancing the display effect of the display device 10c.

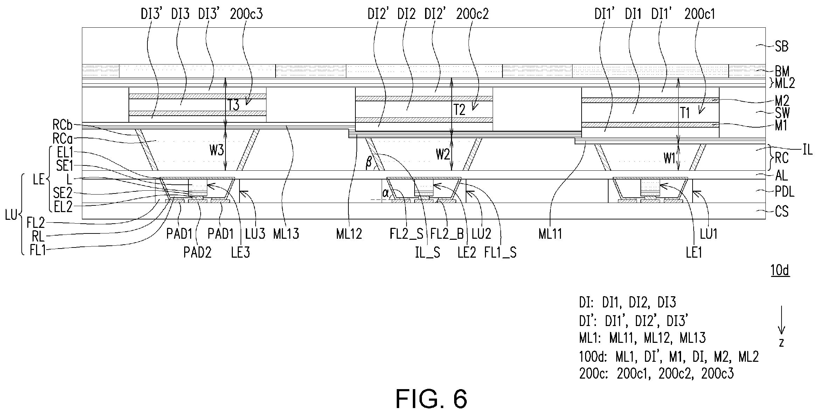

FIG. 6 is a schematic partial cross-sectional diagram of a display device according to a fourth embodiment of the disclosure. It should be noted that the embodiment depicted in FIG. 4 may adopt the reference numbers and some content from the embodiment depicted in FIG. 2, where the same or similar reference numbers serve to represent the same or similar elements, and the description of the same technical content is omitted.

With reference to FIG. 6, at least one difference between a display device 10d depicted in the present embodiment and the aforementioned display device 10c lies in that a resonant cavity structure 200c of a light adjustment layer 100d in the display device 10d has a design different from that of the resonant cavity structure 200b, where a position of a resonant cavity structure 200c1 corresponds to the position of the resonant cavity structure 200b1, a position of the resonant cavity structure 200c2 corresponds to the position of the resonant cavity structure 200b2, and a position of the resonant cavity structure 200c3 corresponds to the position of the resonant cavity structure 200b3.

More specifically, in the present embodiment, the light adjustment layer 100d includes a matching layer ML1, a matching layer ML2, two dielectric layers DI', a first metal layer M1, a dielectric layer DI, and a second metal layer M2, where the two dielectric layers DI', the first metal layer M1, the dielectric layer DI, and the second metal layer M2 constitute a dielectric layer/metal layer/dielectric layer/metal layer/dielectric layer stacked structure. The matching layer ML1 is, for instance, disposed on the first metal layer M1, the matching layer ML2 is, for instance, disposed between the matching layer ML1 and the opposite substrate SB, and the aforesaid dielectric layer/metal layer/dielectric layer/metal layer/dielectric layer stacked structure is, for instance, disposed between the matching layer ML1 and the matching layer ML2. That is, the two dielectric layers DI' are respectively disposed between the matching layer ML1 and the first metal layer M1 and between the second metal layer M2 and the matching layer ML2, and the dielectric layer DI is disposed between the first metal layer M1 and the second metal layer M2.

The descriptions of materials included in and thicknesses of each of the matching layer ML1, the matching layer ML2, the two dielectric layers DI', the first metal layer M1, the dielectric layer DI, and the second metal layer M2 may be referred to as those provided in the previous embodiment and will not be repeated hereinafter.

It is worth noting that since the display device 10d provided in the present embodiment includes relatively more metal layers, the penetration spectrum characteristics of light may be improved, thereby further enhancing the display effect of the display device 10d.

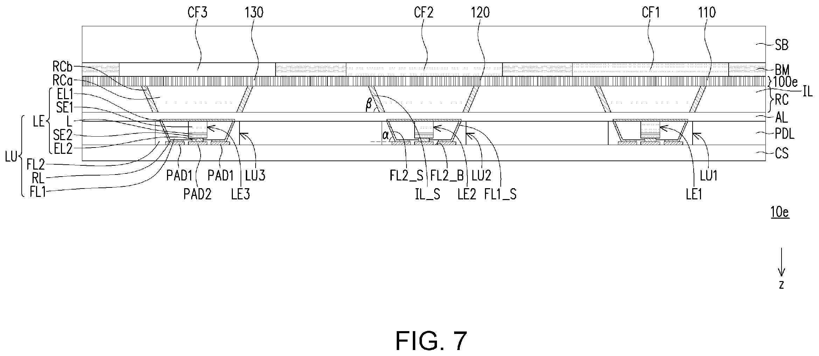

FIG. 7 is a schematic partial cross-sectional diagram of a display device according to a fifth embodiment of the disclosure. It should be noted that the embodiment depicted in FIG. 4 may adopt the reference numbers and some content from the embodiment depicted in FIG. 2, where the same or similar reference numbers serve to represent the same or similar elements, and the description of the same technical content is omitted.

With reference to FIG. 7, at least one difference between a display device 10e depicted in the present embodiment and the aforementioned display device 10a lies in that a light adjustment layer 100e in the display device 10e includes a wire grid polarizer.

The wire grid polarizer included in the light adjustment layer 100e may be, for instance, a metal wire grid, which may, for instance, be formed by arranging a plurality of metal conductive wires at a specific spacing, which should however not be construed as a limitation in the disclosure.

Through the design of the wire grid polarizer, the light adjustment layer 100e may allow light with some specific polarization state to pass through while reflecting light with other polarization states. When the polarization state of the reflected light changes within the light collection layer RC, the light may be incident on the light adjustment layer 100e again. For instance, the light adjustment layer 100e may allow S-waves in the light to pass through while reflecting P-waves in the light, where the reflected P-waves may be reflected and/or scattered within the light collection layer RC, such that after the polarization state of the P-waves changes to the S-waves, the light may be incident on the light adjustment layer 100e again. In view of the above, the intensity of light passing through the light adjustment layer 100e in the front view direction may be improved, thereby enhancing the display effect of the display device 10e.

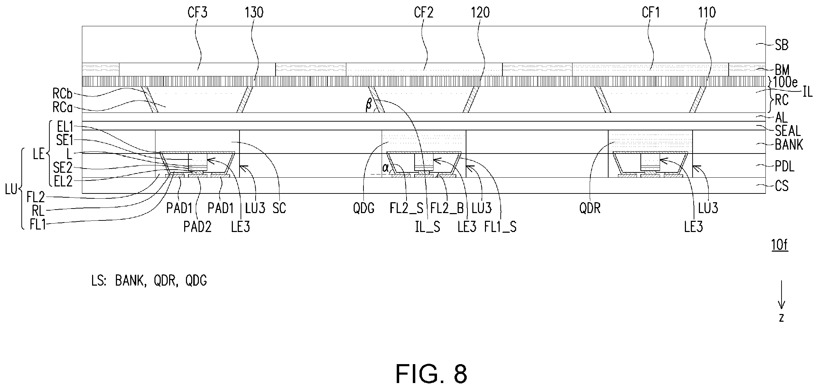

FIG. 8 is a schematic partial cross-sectional diagram of a display device according to a sixth embodiment of the disclosure. It should be noted that the embodiment depicted in FIG. 4 may adopt the reference numbers and some content from the embodiment depicted in FIG. 2, where the same or similar reference numbers serve to represent the same or similar elements, and the description of the same technical content is omitted.

With reference to FIG. 8, at least one difference between a display device 10f depicted in the present embodiment and the aforementioned display device 10e lies in that the display device 10f further includes a light conversion structure LS.

In the present embodiment, the light conversion structure LS includes a bank layer BANK, a wavelength conversion layer QDR, and a wavelength conversion layer QDG. Additionally, in the present embodiment, the light-emitting element LE in each of the light-emitting units LU emits blue light.

The bank layer BANK is, for instance, disposed on the pixel definition layer PDL. In some embodiments, the bank layer BANK may be a grid structure including a plurality of openings, where in the top view direction z of the display device 10f, the openings of the bank layer BANK may each correspond to the openings of the pixel definition layer PDL and the openings of the light shielding structure BM.

The wavelength conversion layer QDR is, for instance, disposed in one of the openings of the bank layer BANK, and is, for instance, located between the red filter unit CF1 and the blue light-emitting unit LU3. The wavelength conversion layer QDG is, for instance, disposed in another of the openings of the bank layer BANK, and is, for instance, located between the green filter unit CF2 and the blue light-emitting unit LU3. Specifically, in the top view direction z of the display device 10f, the wavelength conversion layer QDR may overlap with the red filter unit CF1 and the corresponding blue light-emitting unit LU3, and the wavelength conversion layer QDG may overlap with the green filter unit CF2 and the corresponding blue light-emitting unit LU3. In some embodiments, materials of the wavelength conversion layer QDR and the wavelength conversion layer QDG may respectively include QD materials, phosphorescent materials, fluorescent materials, other appropriate wavelength conversion materials, or a combination thereof. In other words, the wavelength conversion layer QDR and the wavelength conversion layer QDG may each convert the blue light emitted by the blue light-emitting unit LU3 into light having another wavelength. In the present embodiment, the colors of the light having another wavelength converted by each of the wavelength conversion layer QDR and the wavelength conversion layer QDG may roughly correspond to the colors of the red filter unit CF1 and the green filter unit CF2.

In the present embodiment, the display device 10f further includes a scattering layer SC and a sealing layer SEAL.

The scattering layer SC is, for instance, disposed in yet another of the openings of the bank layer BANK, and is, for instance, located between the blue filter unit CF3 and the blue light-emitting unit LU3. Specifically, in the top view direction z of the display device 10f, the scattering layer SC may overlap with the blue filter unit CF3 and the corresponding blue light-emitting unit LU3. In some embodiments, the scattering layer SC includes an organic material and TiO₂ particles located therein to scatter the blue light emitted by the blue light-emitting unit LU3, which should however not be construed as a limitation in the disclosure.

The sealing layer SEAL is, for instance, disposed on the circuit substrate CS, and the sealing layer SEAL and the circuit substrate CS together form an accommodation space, for instance. A material of the sealing layer SEAL may include silicon oxide, silicon nitride, silicon oxynitride, or a combination thereof. Specifically, the sealing layer SEAL extends from the circuit substrate CS to the outermost sidewalls of the bank layer BANK and the pixel definition layer PDL (not shown in FIG. 8), for instance, and further extends to the top surfaces of the bank layer BANK, the wavelength conversion layer QDR, the wavelength conversion layer QDG, and the scattering layer SC, so as to form an accommodation space that at least encapsulates the light-emitting units LU, thereby reducing the possibility that the wavelength conversion layer QDR, the wavelength conversion layer QDG, and the light-emitting units LU are affected by moisture and/or oxygen in the external environment.

To sum up, the electronic device provided in some embodiments of the disclosure includes a stacked structure design composed of the light collection layer, the light adjustment layer, and the color filter layer, where the light adjustment layer includes the Bragg reflection layer and/or the resonant cavity structure composed of the metal layer and the dielectric layer. Therefore, the electronic device provided in some embodiments of the disclosure may adjust the emission angle of light to enhance the intensity of the light in the front view direction, thereby improving the utilization efficiency of light.

Furthermore, in the electronic device provided in some other embodiments of the disclosure, the light adjustment layer includes the wire grid polarizer. Therefore, the electronic device provided in some other embodiments of the disclosure may adjust the polarization state of light to enhance the intensity of the light in the front view direction, thereby improving the utilization efficiency of light.

## Claims

1. A display device (10, 10a, 10b, 10c, 10d, 10e, 10f), comprising:
a circuit substrate (CS);
a plurality of light-emitting units (LU), disposed on the circuit substrate (CS);
a light collection layer (RC), disposed on the plurality of light-emitting units (LU) and comprising a plurality of penetrating portions (RCa) and a plurality of reflecting portions (RCb) disposed around the plurality of penetrating portions (RCa), wherein the plurality of penetrating portions (RCa) respectively overlap with the plurality of light-emitting units (LU);
a light adjustment layer (100a, 100b, 100c, 100d, 100e), disposed on the light collection layer (RC); and
a color filter layer (CF), disposed on the light adjustment layer (100a, 100b, 100c, 100d, 100e) and comprising a plurality of color filter units (CF1, CF2, CF3) respectively overlapping with the plurality of penetrating portions (RCa).

2. The display device (10, 10a, 10b, 10c, 10d, 10e, 10f) according to claim 1, wherein the plurality of light-emitting units (LU) are electrically connected to corresponding pads (PAD1, PAD2) in the circuit substrate (CS).

3. The display device (10, 10a, 10b, 10c, 10d, 10e, 10f) according to claim 1, wherein the plurality of light-emitting units (LU) comprise a red light-emitting unit (LU1), a green light-emitting unit (LU2), and a blue light-emitting unit (LU3), and the light adjustment layer (100a, 100b, 100c, 100d, 100e) comprises a first distributed Bragg reflector (110), a second distributed Bragg reflector (120), and a third distributed Bragg reflector (130) respectively overlapping the red light-emitting unit (LU1), the green light-emitting unit (LU2), and the blue light-emitting unit (LU3).

4. The display device (10, 10a, 10b, 10c, 10d, 10e, 10f) according to claim 3, wherein the first distributed Bragg reflector (110), the second distributed Bragg reflector (120), and the third distributed Bragg reflector (130) respectively comprise a plurality of alternately stacked high-refractive-index sublayers and low-refractive-index sublayers.

5. The display device (10, 10a, 10b, 10c, 10d, 10e, 10f) according to claim 4, wherein at least two of the first distributed Bragg reflector (110), the second distributed Bragg reflector (120), and the third distributed Bragg reflector (130) comprise different numbers of sublayers.

6. The display device (10, 10a, 10b, 10c, 10d, 10e, 10f) according to claim 1, wherein one of the plurality of light-emitting units (LU) has a taper angle (α) of 30° to 70°.

7. The display device (10, 10a, 10b, 10c, 10d, 10e, 10f) according to claim 1, wherein the light collection layer (RC) has a taper angle (β) of 30° to 70°.

8. The display device (10, 10a, 10b, 10c, 10d, 10e, 10f) according to claim 1, wherein each of the plurality of light-emitting units (LU) comprises a light-emitting element (LE), and the light-emitting element (LE) is a vertical embedded flip-chip micro light-emitting diode with a flip-chip structure.

9. The display device (10, 10a, 10b, 10c, 10d, 10e, 10f) according to claim 1, wherein the light adjustment layer (RC) comprises a wire grid polarizer.

10. The display device (10, 10a, 10b, 10c, 10d, 10e, 10f) according to claim 1, wherein the plurality of light-emitting units (LU) comprise a red light-emitting unit (LU1), a green light-emitting unit (LU2), and a blue light-emitting unit (LU3), and the plurality of color filter layers (CF) comprise a red filter unit (CF1), a green filter unit (CF2), and a blue filter unit (CF3) respectively overlapping the red light-emitting unit (LU1), the green light-emitting unit (LU2), and the blue light-emitting unit (LU3).

11. The display device (10, 10a, 10b, 10c, 10d, 10e, 10f) according to claim 1, wherein each of the plurality of light-emitting units (LU) comprises a light-emitting element (LE), a filling layer (FL2), and a reflective layer (RL), the filling layer (FL1, FL2) encapsulates the light-emitting element (LE), and the reflective layer (RL) is disposed on a sidewall of the filling layer (FL2).

12. The display device (10, 10a, 10b, 10c, 10d, 10e, 10f) according to claim 11, wherein the each of the plurality of light-emitting units further comprises a transparent conductive layer (EL1), the transparent conductive layer (EL1) is disposed on an upper surface of the light-emitting element (LE), the light-emitting element (LE) has a first-type semiconductor layer (SE1), a second-type semiconductor layer (SE2), and a light-emitting layer (L), and the first-type semiconductor layer (SE1) is electrically connected to the reflective layer (RL) through the transparent conductive layer (EL1).

13. The display device (10, 10a, 10b, 10c, 10d, 10e, 10f) according to claim 1, further comprising an adhesive layer (AL) disposed between the circuit substrate (CS) and the light collection layer (RC).

14. The display device (10, 10a, 10b, 10c, 10d, 10e, 10f) according to claim 1, wherein the light adjustment layer (100a, 100b, 100c, 100d, 100e) comprises a resonant cavity structure (200a, 200b, 200c) which comprises at least one metal layer (M1, M2) and at least one dielectric layer (DI1).

15. The display device (10, 10a, 10b, 10c, 10d, 10e, 10f) according to claim 14, wherein the light adjustment layer (100a, 100b, 100c, 100d, 100e) comprises a stack structure sequentially including a first metal layer (M1), the at least one dielectric layer (DI1), and a second metal layer (M2).
